# EUROPEAN PATENT APPLICATION

(11) **EP 4 530 369 A1**
(43) Date of publication of application: **02.04.2025**
(21) Application number: 23201048.8
(22) Date of filing: 29.09.2023
(51) Int. Cl.: C23C 14/04, C23C 14/24

(54) **CARRIER FOR LASER INDUCED FORWARD TRANSFER AND TRANSFER APPARATUS COMPRISING THE SAME**

(71) Applicant: Nexperia B.V., 6534 AB Nijmegen (NL)
(72) Inventor: Stokkermans, Joep, Nijmegen (NL); Wesselingh, Jasper, Nijmegen (NL)
(74) Representative: Pjanovic, Ilija

(57) **Abstract**

The present disclosure generally relates to a carrier for laser induced forward transfer of a target material and to a transfer apparatus comprising such a carrier.

The carrier comprises an optically transparent substrate and a target layer arranged on the substrate, wherein the target layer comprises one or more segments of said target material, and wherein the carrier is configured to release a segment among the one or more segments upon receiving laser light that is directed towards that segment of the target layer.

The substrate further comprises an optically transparent secondary support layer, and an optically transparent primary support layer attached to the secondary support layer, said primary support layer comprising one or more regions of an optically transparent first material, wherein the secondary support layer has a material composition different from the first material for limiting a flow of heat away from the primary support layer during the LIFT process.

## Description

### FIELD

The present disclosure generally relates to a carrier for laser induced forward transfer of a target material and to a transfer apparatus comprising such a carrier.

### BACKGROUND

Carriers for laser inducted forward transfer, LIFT, of a target material are known in the art. These carriers typically comprise an optically transparent substrate on which a target layer is arranged. The target layer comprises one or more segments of the target material. By illuminating the target material using laser light through the optically transparent substrate, the target material is locally melted and a droplet from the target material is released.

In other known embodiments, an absorbing layer is arranged in between the target material and the substrate. In this case, the region in the absorbing layer which is directly adjacent to the part of the target material that should be released is illuminated using laser light. The absorbing layer absorbs at least part of the incident laser light, thereby causing a more gradual heating and release of the target material.

Regardless of whether an absorbing layer is used or not, sufficient optical energy must be provided via the laser. A measure for the required energy may typically be expressed as `fluence', or the amount of energy conveyed by the laser pulse divided by the area it is illuminating.

At least for the purpose of energy efficiency as well as cost-effectiveness, there is a need for improving (i.e., reducing) the fluence required for effectuating the LIFT process.

### SUMMARY

It is an object of the present disclosure to provide a carrier for LIFT in which the abovementioned problems do not occur, or hardly so.

According to an aspect of the present disclosure, the substrate comprises an optically transparent secondary support layer, and an optically transparent primary support layer attached to the secondary support layer. The primary support layer comprises one or more regions of an optically transparent first material. Additionally, the secondary support layer has a material composition that is different from the first material for limiting a flow of heat away from the primary support layer during the LIFT process.

The Applicant has found that conventional carriers for LIFT applications may have an associated disadvantage in that the substrate may absorb heat and effectively act as a heatsink. When laser light is applied to the carrier, part of the energy that should have been absorbed by the absorbing layer or target layer will instead flow into the substrate and away from the absorbing layer or target layer. As a result, the fluence required to release segments of the target layer from the carrier may be significantly higher than the energy absorbed by the carrier.

In accordance with the present disclosure, the substrate is not made from a single material. Instead, the substrate comprises a primary support layer on which the target layer is arranged, and a secondary support layer that is configured to limit a flow of heat away from the primary support layer during the LIFT process. According to the present disclosure, this is achieved using a carrier in which the material composition of the primary support layer and that of the secondary support layer is different. In this manner, the secondary support layer can be optimally designed for features such as mechanical stability, whereas the primary support layer can be designed to be able to withstand the high temperatures during the LIFT process.

The Applicant has found that, compared to conventional carriers which may use glass substrates, the use of a secondary support layer and primary support layer in accordance with the present disclosure can provide a more than ten times reduction in fluence required to activate the LIFT process.

Moreover, in accordance with the present disclosure, key properties of the substrate in prior art systems can be maintained with the arrangement described above. For example, the structure can remain chemically similar to conventional 'glass' carriers, and the interface between the primary support layer and the absorbing layer or target layer can still withstand sufficiently high temperatures as is the case in conventional carriers.

The thermal diffusivity of the material composition can be at least 2 times smaller than the thermal diffusivity of the first material, preferably at least 5 times smaller, and more preferably at least 10 times smaller.

The carrier may further comprise an absorbing layer attached to the primary support layer and arranged in between the primary support layer and the target layer. The absorbing layer may contact the one or more regions of a first material. Furthermore, the absorbing layer can be configured to release a respective segment among the one or more segments of the target layer when a region of the absorbing layer directly adjacent to that respective segment is illuminated using laser light. The absorbing layer may comprise a contiguous layer that covers the one or more regions of the primary support layer. The absorbing layer preferably covers the primary support layer entirely. Alternatively, the absorbing layer may comprise a plurality of mutually separated regions, each region of the absorbing layer directly contacting a respective region among the one or more regions of the primary support layer.

The target layer can also be directly attached to the primary support layer. In this case, it contacts the one or more regions of a first material. Furthermore, the target layer can be configured to release a segment among the one or more segments of the target layer when that segment is illuminated using laser light.

The secondary support layer may comprise a support body, wherein the support body is made from a second material different from the first material. In addition, the carrier may further comprise an intermediate layer, wherein the support body is connected to the primary support layer through the intermediate layer.

The intermediate layer may comprise an adhesive layer or coupling agent by which the support body is fixedly attached to the primary support layer.

Alternatively, the intermediate layer may comprise a first body made from the second material. This first body may comprise a plurality of cavities or recesses that either hold a gaseous medium or are filed with a third material different from the first material and second material. The first body is preferably integrally connected to the support body.

Alternatively, the intermediate layer may comprise a second body made from the first material. This second body may comprise a plurality of cavities or recesses that hold a gaseous medium and/or are filed with a third material different from the first material and second material. The second body is preferably integrally connected to the primary support layer.

The use of recesses or cavities filled with the third material is configured to lower the effective thermal conductivity of a border region near the interface between the secondary support layer and the primary support layer.

The target layer can be a contiguous layer. Alternatively, the target layer may comprise a plurality of mutually separated segments of the target material. In this case, the primary support layer may comprise a plurality of recesses, wherein each segment is received in a respective recess. Having discrete recesses allows a more precise control of the amount of target material that is released.

The primary support layer can be entirely formed by a single region of the first material. Alternatively, the primary support layer may comprise a body of the second material, wherein the one or more regions of the first material are arranged in the body of the second material. For example, the primary support layer may have been etched to define a plurality of recesses after which the first material is arranged inside the recesses.

The primary support layer may have a thickness in a range between 10 and 300 micrometer. The secondary support layer may have a thickness in a range between 30 and 3000 micrometer. When applicable, the absorbing layer may have a thickness in a range between 0.1 and 10 micrometer. When applicable, the intermediate layer having the body made from the first material may have a thickness in a range between 10 and 300 micrometer, and when applicable, the intermediate layer having the body made from the second material may have a thickness in a range between 10 and 100 micrometer. The intermediate layer that comprises an adhesive layer or coupling agent may have a thickness in between 10 and 100 micrometer.

The first material may be any one or more from the group consisting of glass, such as BK7 (which is a type of borosilicate glass) or quartz, ceramic and siloxane. The second material may be any one or more from the group consisting of polyethylene terephthalate, `PET', polyethylene naphthalate, `PEN', polyimide, 'PI', and polyvinylchloride, 'PVC'. The third material may be any one or more from the group consisting of aerogel and siloxane. The adhesive layer or coupling agent may be any one or more from the group consisting of epoxy, acrylic and benzocyclobutene. The absorption layer may be any one or more from the group of metals consisting of molybdenum, titanium, nickel, silver, and aluminum. The target layer can be any one or more from the group consisting of solder paste, epoxy, anisotropic conductive adhesive or flux.

The carrier can be curved and/or flexible. For example, such carrier could be used in combination with curved stages to which the carrier is to be coupled.

According to another aspect of the present disclosure, a transfer apparatus is provided. The apparatus comprises a first stage, and a carrier as above arranged on the first stage. The apparatus further comprises a laser for generating laser light for causing the carrier to release a segment among the one or more segments upon receiving the laser light that is directed towards that segment of the target layer. The apparatus also includes a second stage for holding a receptor substrate, a driving system for driving the first stage and second stage, and a controller for controller the driving system and the laser.

The laser may have a position that is fixed in space, for example referring to a supporting surface or frame. The first stage may be configured to be moved using the driving system to change the mutual positioning between the carrier and the laser. In this manner, the laser may each time cause the release of a different segment. Similarly, the controller may control the driving system to move the second stage on which a receptor substrate is held or can be held. In this manner, the position at which the released segment of target material is arranged on the receptor substrate can be varied, for example for generating a pattern on the receptor substrate.

### DETAILED DESCRIPTION

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figures 1A and 1B illustrate a cross-sectional view of an embodiment of a carrier and the LIFT process that uses such carrier, respectively, in accordance with the present disclosure;
Figures 2A-2G illustrate further embodiments of carriers in accordance with the present disclosure; and
Figure 3 illustrates an embodiment of a transfer apparatus in accordance with the present disclosure.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the detailed description using the singular or plural number may also include the plural or singular number respectively. The word "or," in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the detailed description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms.

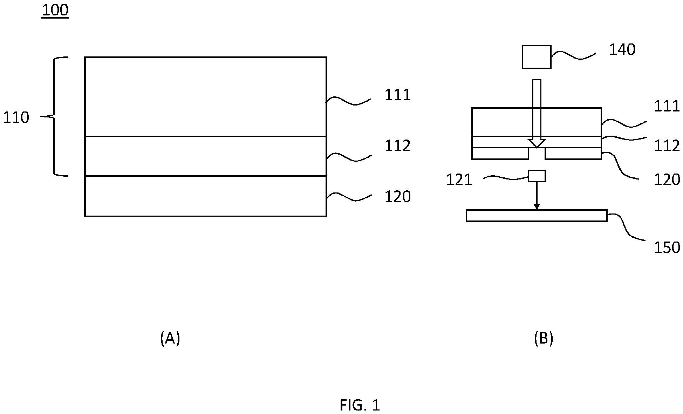

Figure 1A illustrates a cross-sectional view of a carrier 100 in accordance with the present disclosure. It comprises an optically transparent substrate 110 and a target layer 120 arranged on substrate 110. Target layer 120 comprises one or more segments of a target material. Substrate 110 comprises an optically transparent secondary support layer 111, and an optically transparent primary support layer 112 attached to secondary support layer 111.

Carrier 100 is configured to release a segment 121 among the one or more segments upon receiving laser light from a laser 140 that is directed towards that segment of target layer 120. This process is shown in more detail in figure 1B, where segment 121 of target layer 120 is released and falls onto and/or is expelled or propelled towards a receptor substrate 150.

Primary support layer 112 comprises one or more regions of an optically transparent first material. Secondary support layer 111 has a material composition that is different from the first material for limiting a flow of heat away from primary support layer 112 during the LIFT process.

In an embodiment, primary support layer 112 is formed entirely by the first material. This material can for example be one or more of glass, e.g., quartz glass or BK7, ceramic or siloxane. The first material is preferably glass. Secondary support layer 111 can be entirely formed by a second material. This material can for example be one or more of polyethylene terephthalate (PET), polyethylene naphthalate (PEN), polyimide (PI) and polyvinylchloride (PVC). The second material is preferably PET.

When light is incident on target layer 120, this layer will be locally heated and/or partially evaporated causing the release of segment 121. During the LIFT process, target layer 120 may achieve relatively high temperatures. Accordingly, primary support layer 112 should be able to withstand temperatures at least equal to the melting point of the target material. Secondary support layer 111 limits heat flow away from primary support layer 112. In this manner, target layer 120 reaches its melting point more quickly thereby lowering the fluence required for the LIFT process.

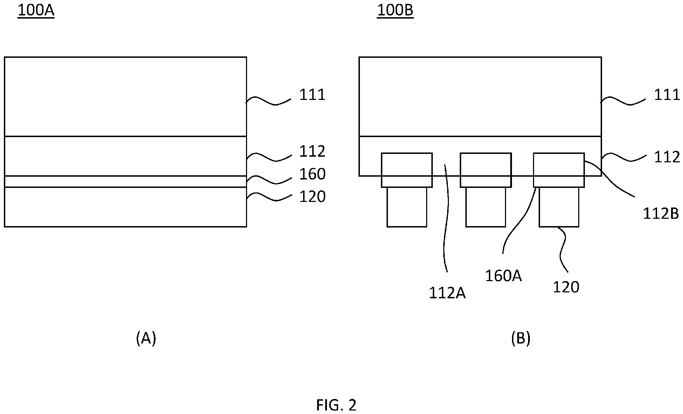

Figures 2A-2G illustrate further embodiments of carriers in accordance with the present disclosure.

Carrier 100A shown in figure 2A differs from carrier 100 shown in figure 1A in that an absorbing layer 160 is used that is arranged in between target layer 120 and primary support layer 112. Absorbing layer 160 has a high adsorption for the light energy contained in the laser light. When absorbing the energy, absorbing layer 160 smoothens the heating up of the target layer and provides for a more controlled release thereof. Using absorbing layer 160, one can therefore optimize the properties for the release process separate from the requirements of target layer 120 when this later layer is arranged on a receptor substrate. Absorbing layer 160 can for example be molybdenum, titanium, nickel, aluminum or silver.

Carrier 100B shown in figure 2B differs from carrier 100 in that primary support layer 112 is not formed solely from the first material. Rather, primary support layer 112 comprises a body 112A made of the second material. Body 112A comprises regions 112B of the first material. In addition, instead of being a contiguous layer, the absorbing layer comprises different segments 160A that are mutually separated. Similarly, target layer 120 comprises multiple segments that are mutually separated and that are aligned with regions 112B.

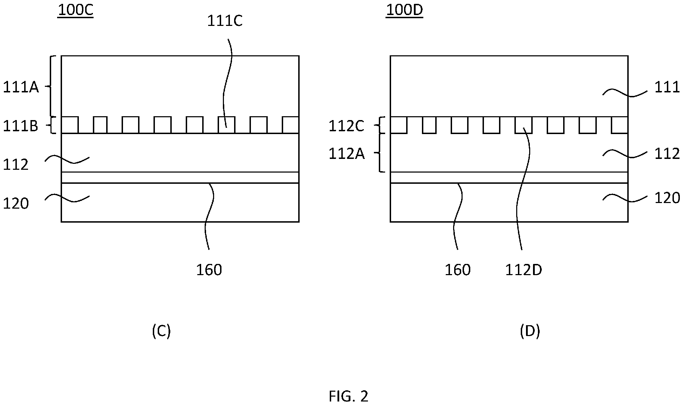

Carrier 100C shown in figure 2C differs from carrier 100A in that thermal barrier 111 comprises a carrier body 111A. Carrier 100C further comprises an intermediate layer 111B that is integrally connected to carrier body 111A and by which carrier body 111A is connected to primary support layer 112. Intermediate layer 111B comprises a body of the second material that comprises a plurality of recess or cavities 111C that are filled with a gaseous medium.

Carrier 100D shown in figure 2D differs from carrier 100A in that thermal barrier 111 comprises a carrier body 111A. Primary support layer 112 comprises a body 112A of the first material. Carrier 100D further comprises an intermediate layer 112C of the first material that comprises a plurality of recess or cavities 112D that are filled with a gaseous medium. Intermediate layer 112C is integrally connected to body 112A.

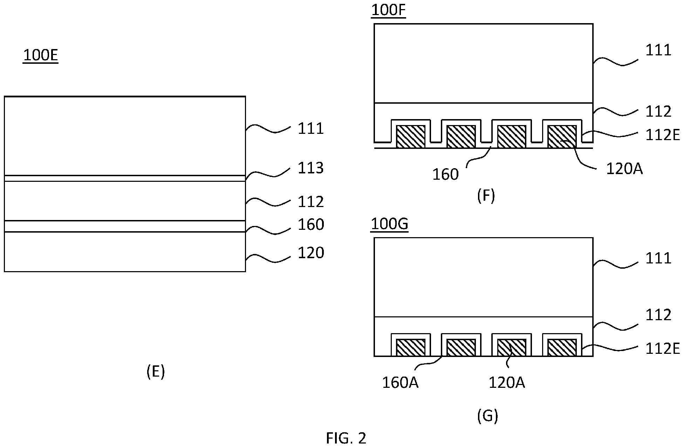

Carrier 100E shown in figure 2E differs from carrier 100A in that thermal barrier 111 comprises a carrier body 111A. Carrier 100E further comprises an intermediate layer 113 in the form of an adhesive layer or coupling agent by which support body 111A is connected to primary support layer 112.

Carrier 100F shown in figure 2F and carrier 100G shown in figure 2G differ from carrier 100 in that primary support layer 112 comprises a plurality of recesses 112E in which an absorbing layer is arranged. In carrier 100F, an absorbing layer 160 is used that covers recesses 112E. In carrier 100G, the absorbing layer is formed by a plurality of mutually separated regions 160A arranged in recesses 112E. Both in carrier 100F and carrier 100G, the target layer comprises a plurality of mutually separated segments 120A of the target material arranged in recesses 112E. When carriers 100F, 100G are illuminated using laser light, discrete and well-defined amounts of the target material are released.

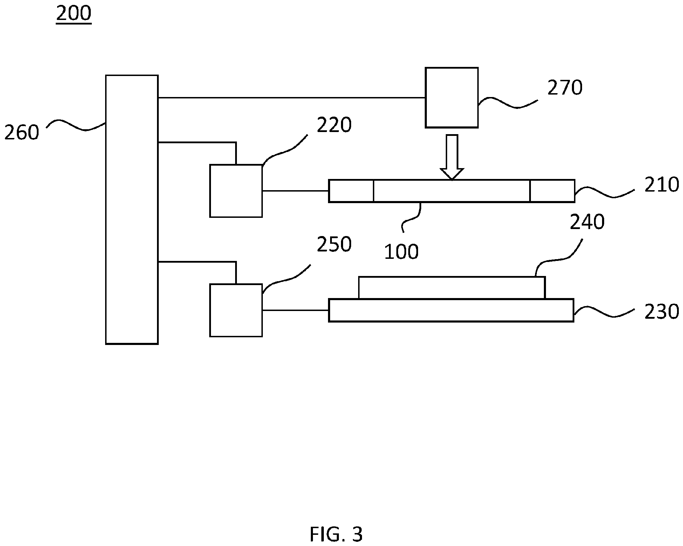

Figure 3 illustrates an embodiment of a transfer apparatus 200 in accordance with the present disclosure. Transfer apparatus 200 comprises a stage 210 to which carrier 200 is coupled. Stage 210 is configured to move carrier 200, for example in an X-Y plane parallel to a supporting floor on which transfer apparatus 200 is arranged. Transfer apparatus 200 comprises a drive 220 for moving stage 210. It further includes a stage 230 that supports a receptor substrate 240 that is configured to receive the segments of the third material released from carrier 100. Stage 230 is configured to move receptor substrate 240, for example in the X-Y plane. A drive 250 is used for moving stage 230. Transfer apparatus 200 comprises a controller 260 for controlling drives 220, 250, which are part of a driving system. Controller 260 further controls laser 270 that is configured to emitting laser light towards carrier 100 for the purpose of releasing a segment of the target material.

Typically, laser 270 and controller 260 have a fixed position, whereas carrier 100 and receptor substrate 240. During operation, carrier 100 is moved in the X-Y plane to bring different segments of the target layer into alignment with laser 270. Similarly, receptor substrate 240 is moved in the X-Y plane to allow receptor substrate 240 to receive segments of the target layer at different positions on receptor substrate 240.

The embodiments presented in figures 1-3, are related to carriers directed at reducing the fluence required for the performing the LIFT process. To that end, the substrate known from prior art carriers is replaced by a secondary support layer and a primary support layer. Having realized the secondary support layer and primary support layer with different material compositions, allows the different layers to be optimized for their function. For example, the secondary support layer should reduce or limit the flow of heat away from the primary support layer, whereas the primary support layer itself should be able to withstand the high temperatures associated with the LIFT process.

However, aspects of the present disclosure also allow further optimizations to be obtained. For example, the secondary support layer can be designed for flexibility so that the carrier as a whole is flexible. Such flexible carrier could be manipulated using a stage that is non-planar, such as a drum. Typically, in such embodiments, the primary support layer is sufficiently thin. According to other aspects of the present disclosure, the carrier is designed to be flexible without being directed to obtain a lower fluence. Embodiments of such aspects can be described by the appended claims with the exception that the aspect of the secondary support layer having a material composition different from the first material for limiting a flow of heat away from the primary support layer during the LIFT process is replaced by the feature that the secondary support layer has a material composition different from the first material for enabling the carrier to be flexible.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including various modifications and/or combinations of features from different embodiments, without departing from the scope of the present disclosure as defined by the appended claims and, at least in some jurisdictions, their equivalents.

## Claims

1. A carrier for laser induced forward transfer, LIFT, of a target material, comprising an optically transparent substrate and a target layer arranged on the substrate, wherein the target layer comprises one or more segments of said target material, and wherein the carrier is configured to release a segment among the one or more segments upon receiving laser light that is directed towards that segment of the target layer;
wherein the substrate comprises an optically transparent secondary support layer, and an optically transparent primary support layer attached to the secondary support layer, said primary support layer comprising one or more regions of an optically transparent first material, wherein the secondary support layer has a material composition different from the first material for limiting a flow of heat away from the primary support layer during the LIFT process.

2. The carrier according to claim 1, wherein the thermal diffusivity of the material composition is at least 2 times smaller than the thermal diffusivity of the first material, preferably at least 5 times smaller, and more preferably at least 10 times smaller.

3. The carrier according to claim 1 or 2, wherein the carrier further comprises an absorbing layer (160) attached to the primary support layer and arranged in between the primary support layer and the target layer;
wherein the absorbing layer contacts the one or more regions of a first material, the absorbing layer being configured to release a respective segment among the one or more segments of the target layer when a region of the absorbing layer directly adjacent to said respective segment is illuminated using laser light;
wherein the absorbing layer preferably comprises a contiguous layer that covers the one or more regions of the primary support layer, said absorbing layer preferably covering the primary support layer entirely, or wherein the absorbing layer preferably comprises a plurality of mutually separated regions, each region of the absorbing layer directly contacting a respective region among the one or more regions of the primary support layer.

4. The carrier according to claim 1, wherein the target layer is directly attached to the primary support layer and contacts the one or more regions of a first material, wherein the target layer is configured to release a segment among the one or more segments of the target layer when that segment is illuminated using laser light.

5. The carrier according to any of the previous claims, wherein the secondary support layer comprises a support body, wherein the support body is made from a second material different from the first material.

6. The carrier according to claim 5, wherein the carrier further comprises an intermediate layer, wherein the support body is connected to the primary support layer through the intermediate layer.

7. The carrier according to claim 6, wherein the intermediate layer comprises an adhesive layer or coupling agent; or
wherein the intermediate layer comprises a first body made from the second material, said first body comprising a plurality of cavities or recesses that either hold a gaseous medium or are filed with a third material different from the first material and second material, wherein the first body is preferably integrally connected to the support body; or
wherein the intermediate layer comprises a second body made from the first material, said second body comprising a plurality of cavities or recesses that hold a gaseous medium and/or are filed with a third material different from the first material and second material, wherein the second body is preferably integrally connected to the primary support layer.

8. The carrier according to any of the previous claims, wherein the target layer is a contiguous layer; or
wherein the target layer comprises a plurality of mutually separated segments of said target material, the primary support layer preferably comprising a plurality of recesses, wherein each segment is received in a respective recess.

9. The carrier according to any of the previous claims, wherein the primary support layer is entirely formed by a single region of the first material.

10. The carrier according to any of the previous claims, wherein the primary support layer comprises a body of the second material, wherein the one or more regions of the first material are arranged in the body of the second material.

11. The carrier according to any of the previous claims, wherein:
the primary support layer has a thickness in a range between 10 and 300 micrometer;
the secondary support layer has a thickness in a range between 30 and 3000 micrometer;
in so far as depending on claim 2, the absorbing layer has a thickness in a range between 0.1 and 10 micrometer;
in so far as depending on claim 7, the intermediate layer having the body made from the first material has a thickness in a range between 10 and 300 micrometer;
in so far as depending on claim 7, the intermediate layer having the body made from the second material has a thickness in a range between 10 and 100 micrometer;
in so far as depending on claim 7, the intermediate layer that comprises an adhesive layer or coupling agent has a thickness in between 10 and 100 micrometer.

12. The carrier according to any of the previous claims, wherein:
the first material is any one or more from the group consisting of glass, quartz glass or BK7, ceramic or siloxane; and/or
the second material is any one or more from the group consisting of polyethylene terephthalate, PET, polyethylene naphthalate, PEN, polyimide, PI, and polyvinylchloride; and/or
in so far as depending on claim 7, the third material is any one or more from the group consisting of aerogel and siloxane; and/or
in so far as depending on claim 7, the adhesive layer or coupling agent is any one or more from the group consisting of epoxy, acrylic and benzocyclobutene; and/or
in so far as depending on claim 2, the absorbing layer is any one or more from the group consisting of molybdenum, titanium, nickel, silver, and aluminum.

13. The carrier according to any of the previous claims, wherein the target layer is any one or more from the group consisting of solder paste, epoxy, anisotropic conductive adhesive or flux.

14. The carrier according to any of the previous claims, wherein the carrier is curved and/or flexible.

15. A transfer apparatus, comprising:
a first stage;
a carrier as defined in any of the previous claims arranged on the first stage;
a laser for generating laser light for causing the carrier to release a segment among the one or more segments upon receiving the laser light that is directed towards that segment of the target layer; and
a second stage for holding a receptor substrate;
a driving system for driving the first stage and second stage;
a controller for controller the driving system and the laser.
